# EUROPEAN PATENT APPLICATION

(11) **EP 4 261 872 A1**
(43) Date of publication of application: **18.10.2023**
(21) Application number: 22167530.9
(22) Date of filing: 11.04.2022
(51) Int. Cl.: H01L 21/603, H01L 23/48, H01L 21/56, H01L 23/31, H01L 23/495, H01L 23/367, H01L 23/498

(54) **MOLDED ELECTRONIC PACKAGE WITH AN ELECTRONIC COMPONENT ENCAPSULATED BETWEEN TWO SUBSTRATES WITH A SPRING MEMBER BETWEEN THE ELECTRONIC COMPONENT AND ONE OF THE SUBSTRATES AND METHOD FOR MANUFACTURING THE SAME**

(71) Applicant: Nexperia B.V., 6534 AB Nijmegen (NL)
(72) Inventor: Cheam, Hing Suan, Seremban (MY); Tan, Wei Leong, Seremban (MY); Chang, Ting Wei, Seremban (MY)
(74) Representative: Pjanovic, Ilija

(57) **Abstract**

A molded electronic package (1a, 1b) comprises a first substrate (2), a second substrate (3), an electronic component (4) arranged on the first substrate (2), a spring member (5) arranged between the second substrate (3) and the electronic component (4), the spring member (5) comprising a first contact portion (5a) being fixed relative to the second substrate (3) and a second contact portion (5b) physically contacting the electronic component (4), and a body of solidified molding compound (6) encapsulating the electronic component (4) and the spring member (5) and mutually fixing the first substrate (2), the second substrate (3), the electronic component (4) and the spring member (5). The spring member (5) may be fixed to the second substrate (3) by an adhesive layer (e.g., solder). Alternatively or in addition, the spring member (5) may be fixed to the second substrate (3) by a recess in the second substrate (3) in which the first contact portion (5a) is arranged, the recess being configured to mechanically lock a position of the spring member (5) in a direction parallel to the second substrate (3); and/or the spring member (5) may be fixed to the second substrate (3) by one or more protrusions extending from the second substrate (3) and surrounding the first contact portion (5a), the one or more protrusions being configured to mechanically lock a position of the spring member (5) in a direction parallel to the second substrate (3). The second substrate (3) and the spring member (5) may be thermally conductive, wherein at least a portion of a surface of the second substrate (3) is exposed to an outside of the molded electronic package (1a, 1b), the second substrate (3) forming a heatsink for the electronic component (4). The second substrate (3) and the spring member (5) may be electrically conductive, wherein the second substrate (3) comprises: a planar portion (3a), the spring member (5) being arranged in between the planar portion (3a) and the electronic component (4); and a first lead (3b) integrally connected to the planar portion (3a) and extending from said planar portion (3a) and out of the body of solidified molding compound (6), wherein the first lead (3b) is electrically connected to a terminal of the electronic component (4) via the planar portion (3a) and the spring member (5), and forms a package contact of the molded electronic package (1a). Alternatively, the second substrate may comprise a printed circuit board, PCB, comprising a dielectric layer and a circuit arranged on the dielectric layer, wherein the circuit is electrically connected to the electronic component (4) through the spring member (5). The first substrate (2) may be electrically conductive and electrically connected to a terminal of the electronic component (4), wherein the first substrate (2) comprises a pad portion (2a) on which the electronic component (4) is arranged, and wherein the pad portion (2a) comprises a surface that is exposed to an outside of the molded electronic package (6), said surface forming a package contact of the molded electronic package (6), and/or wherein the first substrate (2) further comprises a second lead (2b) integrally formed with the pad portion (2a), said second lead (2b) extending from said pad portion (2a) and out of the body of solidified molding compound (6), wherein the second lead (2b) forms a package contact of the molded electronic package (1a); and/or wherein the electronic component (4) comprises a semiconductor die having a circuit integrated thereon, wherein the circuit comprises a plurality of terminals corresponding to terminals of the electronic component (4), wherein the first substrate (2) preferably comprises a die pad. The molded electronic package (1b) may further comprise: a further package contact (9), a first end thereof being external to the body of solidified molding compound (6), and a second end thereof being encapsulated by the body of solidified molding compound (6); a further spring member comprising a first further contact portion (8a) contacting the second substrate (3), and a second further contact portion (8b) contacting the further package contact (9), wherein the further spring member is electrically conductive, wherein the further spring member is preferably integrally connected to the spring member (5). In a method for manufacturing the molded electronic package (1a, 1b), a molding compound is applied and allowed to solidify to thereby form the body of solidified molding compound (6) upon applying a force (P1, P2, P3) to the second substrate (3), said force (P1, P2, P3) allowing the second contact portion (5b) of the spring member (5) to deform and press against the electronic component (4). At least part of a surface of the second substrate (3) may be kept clear of molding compound, wherein the force (P1) is applied to said part of the surface of the second substrate (3); and/or a first end portion and an opposing second end portion of the second substrate (3) are kept clear of molding compound, wherein the force (P2, P3) is applied to said first end portion and second end portion.

## Description

### FIELD

Aspects of the present disclosure relate to a molded electronic package and a method for manufacturing the same.

### BACKGROUND

Electronic components, such as semiconductor dies, may be arranged inside an electronic package to protect said electronic components from external damages, for example due to mechanical stress. In a molded electronic package, an electronic component can be partially or fully encapsulated by a package material, such as a body of solidified molding compound, thereby protecting said electronic component.

The electronic component in known molded electronic packages comprises a plurality of terminals that are accessible from an outside of the package via package contacts that are at least partially arranged externally to the body of solidified molding compound. The package may then be mounted on an external surface, such as a printed circuit board (PCB), with the package contacts facing the external surface for forming electrical connections to an external circuit.

Typically, the package comprises a substrate that is thermally conductive, electrically conductive, or both. The substrate is attached to the electronic component via an adhesive, such as solder material. In the case of a thermally conductive substrate, the substrate may form a heatsink for the electronic component. In the case of an electrically conductive substrate, the substrate may be electrically connected to a terminal of the electronic component and may form part of a package contact of the package. For example, an electrical connection to at least one of the package contacts may be formed by one or more leads extending from a planar portion of an electrically conductive substrate that is arranged on the electronic component and is electrically connected thereto via a conductive adhesive, such as solder material.

A drawback of the above mentioned known devices is that conductive adhesive on top of the electronic component may have an inconsistent volume during manufacturing, potentially causing the substrate to tilt after attaching it to the electronic component. This can impact the ability of the package to be mounted to an external surface. Furthermore, a flux residue or solder particles on the electronic component may not be removed completely by a flux clean process following the attachment of the substrate to the electronic component. This may significantly impact the reliability of the package and may even lead to failure of the electronic component, for example due to ionic contamination.

### SUMMARY

Aspects of the present disclosure relate to a molded electronic package and a method of manufacturing the same, in which the abovementioned drawback(s) do not occur, or hardly so.

A summary of aspects of certain embodiments disclosed herein is set forth below. It should be understood that these aspects are presented merely to provide the reader with a brief summary of these certain embodiments and that these aspects are not intended to limit the scope of this disclosure. Indeed, this disclosure may encompass a variety of aspects and/or a combination of aspects that may not be set forth.

According to an aspect of the present disclosure, a molded electronic package is provided, comprising a first substrate, a second substrate and an electronic component arranged on the first substrate. The molded electronic package further comprises a spring member arranged between the second substrate and the electronic component, the spring member comprising a first contact portion being fixated relative to the second substrate, and a second contact portion physically contacting the electronic component. Furthermore, the molded electronic package comprises a body of solidified molding compound configured to encapsulate the electronic component and the spring member and to mutually fixate the first substrate, the second substrate, the electronic component and the spring member. The second substrate and the spring member are electrically and/or thermally conductive.

In the molded electronic package according to the present disclosure, the second substrate is connected to the electronic component via the spring member, which, during manufacturing, is deformed and pressed against the electronic component, thereby forming a thermal and/or electrical connection without the need for an adhesive. The body of solidified molding compound mutually fixates the first and second substrate, the electronic component and the spring member and as such maintains the physical connection between the spring member and the electronic component.

The spring member may be fixated to the second substrate by an adhesive layer, preferably comprising a conductive adhesive material such as a solder material. Additionally or alternatively, the spring member may be fixated to the second substrate by a recess in the second substrate in which the first contact portion is arranged, the recess being configured to mechanically lock a position of the spring member in a direction parallel to the second substrate. Additionally or alternatively, the spring member may be fixated to the second substrate by one or more protrusions extending from the second substrate and surrounding the first contact portion, the one or more protrusions being configured to mechanically lock a position of the spring member in a direction parallel to the second substrate.

In this manner, the spring member can be accurately positioned with respect to the electronic component during manufacturing of the molded electronic package.

The second substrate and the spring member may each be thermally conductive. In a further embodiment, at least a portion of a surface of the second substrate may be exposed to an outside of the molded electronic package. In that manner, the second substrate may form a heatsink for the electronic component by conducting heat from the electronic component away from the electronic component and towards an outside of the molded electronic package.

Additionally or alternatively, the second substrate and the spring member may be electrically conductive. In a further embodiment, the second substrate may comprise a planar portion, the spring member being arranged in between the planar portion and the electronic component. The second substrate may further comprise a first lead integrally connected to the planar portion and extending from said planar portion and out of the body of solidified molding compound. The first lead may be electrically connected to a terminal of the electronic component via the planar portion and the spring member, and may form a package contact of the molded electronic package.

The second substrate may comprise a printed circuit board, 'PCB', comprising a dielectric layer and a circuit arranged on the dielectric layer. The circuit may be electrically connected to the electronic component through the spring member.

The spring member may comprise an alloy including copper, such as a beryllium copper alloy or a titanium copper alloy.

The first substrate may be electrically conductive and may be electrically connected to a terminal of the electronic component. The first substrate may comprise a pad portion on which the electronic component is arranged.

The pad portion may comprise a surface that is exposed to an outside of the molded electronic package, and said surface may form a package contact of the molded electronic package. Additionally or alternatively, the first substrate may further comprise a second lead integrally formed with the pad portion, said second lead extending from said pad portion and out of the body of solidified molding compound. The second lead may form a package contact of the molded electronic package.

The electronic component may comprise a semiconductor die having a circuit integrated thereon, the circuit comprising a plurality of terminals corresponding to terminals of the electronic component. The first substrate may comprise a die pad.

The molded electronic package may further comprise a further package contact, a first end thereof being external to the body of solidified molding compound, and a second end thereof being encapsulated by the body of solidified molding compound. Furthermore, the molded electronic package may comprise a further spring member comprising a first further contact portion contacting the second substrate, and a second further contact portion contacting the further package contact. The further spring member may be electrically conductive. In some embodiments, the further spring member may be integrally connected to the spring member.

The planar portion and the pad portion may extend substantially parallel to one another.

According to another aspect of the present disclosure, a method for manufacturing the abovementioned molded electronic package is provided. The method comprises a) providing a first substrate, a second substrate, an electronic component and a spring member. The electronic component is arranged on the first substrate. The second substrate and the spring member are electrically and/or thermally conductive. The method further comprises b) arranging the spring member in between the second substrate and the electronic component, wherein a first contact portion of the spring member is fixated relative to the second substrate, and wherein a second contact portion of the spring member is arranged contacting the electronic component.

The method further comprises c) applying a molding compound, and d) allowing said molding compound to solidify to thereby form a body of solidified molding compound encapsulating the electronic component and the spring member and mutually fixating the first substrate, the second substrate, the electronic component, and the spring member.

The method further comprises applying a force to the second substrate at least during at least part of step d), said force allowing the second contact portion of the spring member to deform and press against the electronic component.

During manufacturing, a force is applied for deforming the spring member and pressing the spring member against the electronic component, which forms a physical contact between the spring member and the electronic component without the need for an adhesive material, such as a conductive adhesive. When the molding compound is sufficiently solidified, no force needs to be applied anymore, since the body of solidified molding compound mutually fixates the spring member to the electronic component. As a result, the drawback(s) of using an adhesive on the electronic component can be mitigated.

Step b) may further comprise fixating the spring member relative to the second substrate by an adhesive layer, preferably comprising a conductive adhesive material such as a solder material. Additionally or alternatively, step b) may further comprise fixating the spring member relative to the second substrate by a recess in the second substrate in which the first contact portion is arranged, the recess being configured to mechanically lock a position of the spring member in a direction parallel to the second substrate. Additionally or alternatively, step b) may further comprise fixating the spring member relative to the second substrate by one or more protrusions extending from the second substrate and surrounding the first contact portion, the one or more protrusions being configured to mechanically lock a position of the spring member in a direction parallel to the second substrate.

At least part of a surface of the second substrate may be kept clear of molding compound, and the force may be applied to said part of the surface of the second substrate. In that case, preferably, said part of the surface is directly above the spring member and the electronic component. Additionally or alternatively, by keeping said part of the surface of the second substrate clear, in the case that the second substrate is thermally conductive, the second substrate may form a heatsink for the electronic component.

A first end portion and an opposing second end portion of the second substrate may be kept clear of molding compound, and the force may be applied to said first end portion and second end portion. Preferably, depending the force may be applied in a balanced manner such that a middle portion in between the first and second end portion, directly adjacent to the spring member, applies a pressure on the spring member directly towards the electronic component. In this manner, a surface of the second substrate need not be exposed for applying the force.

The second substrate and the spring member may be electrically conductive. The spring member may be electrically connected to a terminal of the electronic component, and at least one of the first end portion and second end portion may form a package contact of the molded electronic package, for example in the form of a lead.

The method may further comprise providing a further package contact and a further spring member, the further spring member being electrically conductive and preferably being integrally connected to the spring member. Furthermore, the method may comprise arranging the further spring member in between the second substrate and the further package contact, wherein a first further contact portion of the further spring member contacts the second substrate and a second further contact portion of the further spring member contacts the further package contact.

The further package contact may comprise an end portion that is kept clear of molding compound, and the body of solidified molding compound may mutually fixate the first substrate, the second substrate, the electronic component, the spring member, and the one or more further spring members. The applied force, or a further applied force, may allow the first or second further contact portion of the further spring member to deform and press against the second substrate or the further package contact, respectively.

The electronic component may be fixated to the first substrate using an adhesive layer, preferably a conductive adhesive such as using solder material. Alternatively, the method may comprise fixating the electronic component to the first substrate using an adhesive layer.

### DESCRIPTION OF THE DRAWINGS

Next, the present disclosure will be described in more detail with reference to the appended drawings, wherein:
Figure 1 is an exploded view of a molded electronic package according to an embodiment of the present disclosure;
Figure 2 is a cross-sectional view of a molded electronic package according to an embodiment of the present disclosure;
Figures 3A and 3B are perspective views of a molded electronic package according to an embodiment of the present disclosure;
Figure 4 is a cross-sectional view of a molded electronic package according to an embodiment of the present disclosure;
Figure 5 is an exploded view of a molded electronic package according to an embodiment of the present disclosure;
Figure 6 is a cross-sectional view of a molded electronic package according to an embodiment of the present disclosure; and
Figures 7A and 7B are perspective views of a molded electronic package according to an embodiment of the present disclosure.

The present disclosure is described in conjunction with the appended figures. It is emphasized that, in accordance with the standard practice in the industry, various features are not drawn to scale. In fact, the dimensions of the various features may be arbitrarily increased or reduced for clarity of discussion.

In the appended figures, similar components and/or features may have the same reference label. Further, various components of the same type may be distinguished by following the reference label by a dash and a second label that distinguishes among the similar components. If only the first reference label is used in the specification, the description is applicable to any one of the similar components having the same first reference label irrespective of the second reference label.

Unless the context clearly requires otherwise, throughout the description and the claims, the words "comprise," "comprising," and the like are to be construed in an inclusive sense, as opposed to an exclusive or exhaustive sense; that is to say, in the sense of "including, but not limited to." As used herein, the terms "connected," "coupled," or any variant thereof means any connection or coupling, either direct or indirect, between two or more elements; the coupling or connection between the elements can be physical, logical, electromagnetic, or a combination thereof. Additionally, the words "herein," "above," "below," and words of similar import, when used in this application, refer to this application as a whole and not to any particular portions of this application. Where the context permits, words in the detailed description using the singular or plural number may also include the plural or singular number respectively. The word "or" in reference to a list of two or more items, covers all of the following interpretations of the word: any of the items in the list, all of the items in the list, and any combination of the items in the list.

The teachings of the technology provided herein can be applied to other systems, not necessarily the system described below. The elements and acts of the various examples described below can be combined to provide further implementations of the technology. Some alternative implementations of the technology may include not only additional elements to those implementations noted below, but also may include fewer elements.

These and other changes can be made to the technology in light of the following detailed description. While the description describes certain examples of the technology, and describes the best mode contemplated, no matter how detailed the description appears, the technology can be practiced in many ways. Details of the system may vary considerably in its specific implementation, while still being encompassed by the technology disclosed herein. As noted above, particular terminology used when describing certain features or aspects of the technology should not be taken to imply that the terminology is being redefined herein to be restricted to any specific characteristics, features, or aspects of the technology with which that terminology is associated. In general, the terms used in the following claims should not be construed to limit the technology to the specific examples disclosed in the specification, unless the Detailed Description section explicitly defines such terms. Accordingly, the actual scope of the technology encompasses not only the disclosed examples, but also all equivalent ways of practicing or implementing the technology under the claims.

To reduce the number of claims, certain aspects of the technology are presented below in certain claim forms, but the applicant contemplates the various aspects of the technology in any number of claim forms.

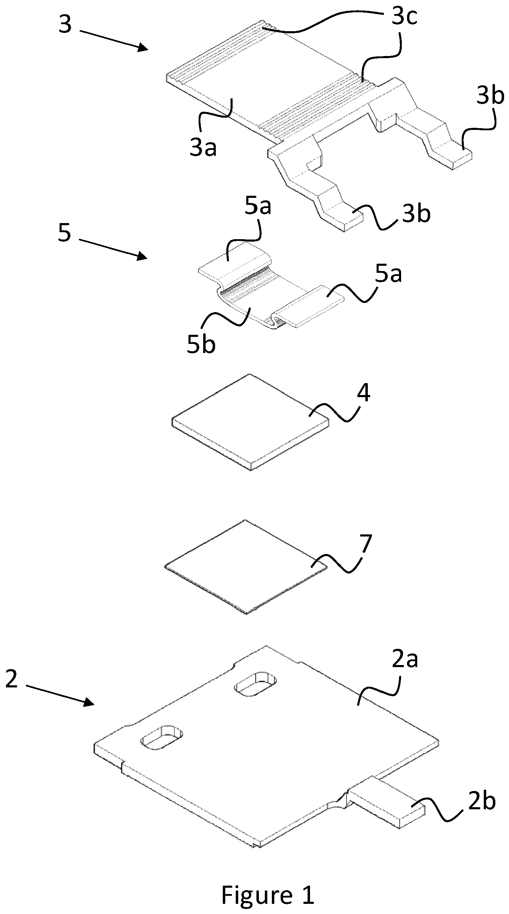

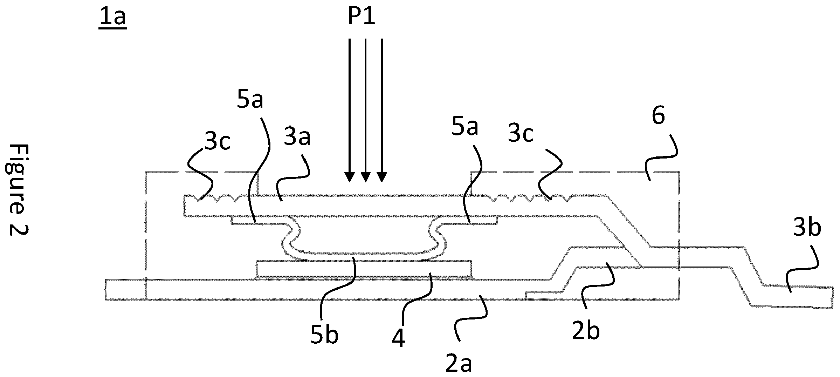

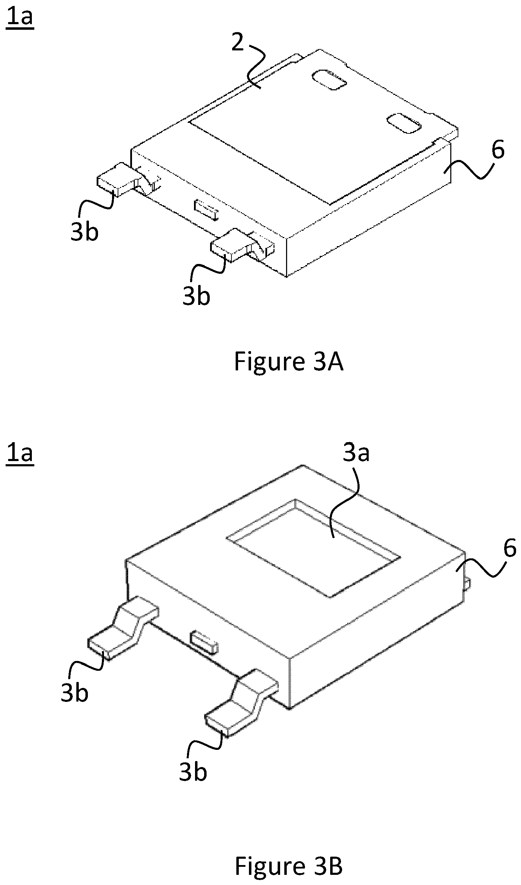

In Figure 1, an exploded view of part of a molded electronic package 1a according to an embodiment of the present disclosure is shown. Figure 2 shows a cross-sectional view of molded electronic package 1a according to an embodiment of the present disclosure, and Figures 3A and 3B show a corresponding perspective view of molded electronic package 1a.

Molded electronic package 1a comprises an electronic component 4 having a plurality of terminals. For example, electronic component 4 is a semiconductor die having a circuit integrated thereon, the circuit comprising said terminals. The terminals may be arranged at or accessible at outer surfaces of electronic component 4, such as a top and bottom surface.

As shown in Figure 2 and Figures 3A and 3B, molded electronic package 1a comprises a body of solidified molding compound 6 that encapsulates electronic component 4 to prevent or at least limit said electronic component 4 from being damaged, such as due to mechanical or thermal stress.

Electronic component 4 is arranged on a pad portion 2a of a first substrate 2. In an embodiment, electronic component 4 is attached to pad portion 2a, for example via an adhesive layer 7. In an example, electronic component 4 is a semiconductor die, and first substrate 2 is a die pad.

First substrate 2 may be electrically conductive and may be electrically connected to a terminal of electronic component 4 arranged at a bottom surface thereof. For example, adhesive layer 7 may be conductive, and first substrate 2 may be electrically connected to electronic component 4 via adhesive layer 7. Examples of conductive adhesive layers include a solder layer, such as tin, or a sinter layer. As shown in Figure 2A, a surface of first substrate 2 may be exposed to an outside of molded electronic package 1a and may form a package contact through which a terminal of electronic component 4 can be accessed. Additionally, or alternatively, one or more leads may extend form pad portion 2a via which said terminal of electronic component 4 can be accessed. In this case, pad portion 2a could also be encapsulated by body of solidified molding compound 6.

First substrate 2 may be additionally or alternatively be thermally conductive and may at least in part form a heatsink for electronic component 4. For example, heat from electronic component 4 may at least in part be conducted to an outside of molded electronic package 1a via first substrate 1. In this embodiment, since pressure is not applied at a top surface of planar portion 3a, said planar portion 3a may be encapsulated by body of solidified molding compound 6 and need not be exposed to an outside of molded electronic package 1a after manufacturing.

Molded electronic package 1a further comprises a second substrate 3 comprising a planar portion 3a and leads 3b. In this embodiment, second substrate 3 is electrically conductive. Leads 3b extend from said planar portion 3a out of body of solidified molding compound 6 to an outside of molded electronic package 1a.Here, leads 3b may be configured to provide external access to a terminal of electronic component. In an example, leads 3b are integrally connected to planar portion 3a.

Furthermore, molded electronic package 1a comprises a spring member 5 having a first contact portion 5a and a second contact portion 5b. In this embodiment, spring member 5 is electrically conductive. Spring member 5 may be a resilient element that can deform from its original shape when a force is applied directly or indirectly to it. Spring member 5 may for example comprise a flexible, electrically conductive material, such as a beryllium copper alloy.

First contact portion 5a is fixated with respect to second substrate 3 and may physically contact second substrate 3 or may be attached thereto. In an example, first contact portion 5a is mechanically locked with second substrate 3 in a direction parallel to planar portion 3a. For example, first contact portion 5a may be arranged in a recess in planar portion 3a preventing or limiting a movement of first contact portion 5a in said direction parallel to parallel portion 3a. Alternatively, or additionally, planar portion 3a comprises one or more protrusions arranged to mechanically lock first contact portion 5a. The present disclosure also envisages other means of fixating spring member 5 to second substrate 3, for example by means of an adhesive, such as a conductive adhesive (e.g., tin), by means of welding, or the like. In this embodiment, spring member 5 is electrically connected to second substrate 3.

Second contact portion 5b physically contacts electronic component 4 and is electrically connected to a terminal of electronic component 4. In this manner, leads 3b and/or planar portion 3a are indirectly electrically connected to said terminal via spring member 5 and may provide external access to said terminal from an outside of molded electronic package 1a.

Body of solidified molding compound 6 mutually fixates first substrate 2, second substrate 3, electronic component 4 and spring member 5.

Second substrate 3 optionally further comprises a mold-lock structure 3c for increasing an adhesiveness of molding compound during and after a molding process, which is described further below. In addition, mold-lock structure 3c prevent or limit a spring-back effect of spring member 5 after molding and after forming body of solidified molding compound 6. In addition, mold-lock structure 3c can also serve as a stress-relief structure during thermal stress, prolonging a reliability of molded electronic package 1a.In an embodiment, mold-lock structure 3ccomprises one or more recesses in planar portion 3a of second substrate 3, for example triangularly shaped recesses as shown in Figures 1 and 2. Said recesses can engage with molding compound during molding and with body of solidified molding compound 6 after molding.

Next, a method for manufacturing molded electronic package 1a according to an embodiment of the present disclosure is described with reference to Figures 1 and 2.

In a first step, first substrate 2, second substrate 3, electronic component 4 and spring member 5 are provided. Electronic component 4 may already be provided on first substrate 2, or the method may comprise arranging electronic component 4 on first substrate 2 or attaching electronic component 4 thereto via adhesive layer 7. Furthermore, spring member 5 may fixated relative to second substrate 3, or the method may further comprise fixating spring member 5 to second substrate 3 as described above. Spring member 5 may be arranged between electronic component 4 and second substrate 3 prior to, during or after fixating spring member 5 relative to second substrate 3.

Next, a molding compound is applied to encapsulate electronic component 4 and spring member 5. Molding compound may also be arranged partially surrounding first substrate 2 and second substrate 3, as shown in Figure 2. Subsequently, the molding compound is allowed to solidify to thereby form body of solidified molding compound 6.

At least during at least part of the step of allowing the molding compound to solidify, a force PI is applied to second substrate 3 to deform spring member 5 and press second contact portion 5b against electronic component 4. During this step, an opposing further force may be applied to first substrate 2, or the structure may be placed on an external surface with first substrate 2 facing said external surface.

The deformation of spring member 5 may increase a contact area between second contact portion 5b and electronic component. In an example, electronic component 4 is a semiconductor die, and second contact portion 5b may be pressed against a metallization layer of said semiconductor die, wherein said metallization layer forms, or is electrically connected to, a terminal of the circuit integrated on semiconductor die.

Once the molding compound is sufficiently solidified, such as when body of solidified molding compound 6 is formed, force PI is no longer required since spring member 5 is mutually fixated with electronic component 4 in its deformed shape, and contact between spring member 5 and electronic component 4 is maintained even without force PI being applied. Body of solidified molding compound 6 protects electronic component 4 from external damages and mutually fixates first substrate 2, second substrate 3, electronic component 4 and spring member 5.

After the molding compound is solidified, a part of planar portion 3a may still be exposed, as shown in Figures 2 and 3B. In so far as second substrate 3 is thermally conductive, this portion may serve as a heatsink for electronic component 4 and may allow part of the heat dissipated in electronic component 4, during operation, to be transported out of molded electronic package 1a via said planar portion 3a.

After body of solidified molding compound 6 is formed, leads 3b may for example be shaped such that a surface thereof is aligned with a bottom surface of molded electronic package 1a. This allows molded electronic package 1 to be easily mounted to a planar external surface, such as a printed circuit board (PCB). For example, leads 3b may be shaped into a gull-wing shape. Alternatively, leads 3b are already pre-formed into a desired shape prior to applying the molding compound and allowing the molding compound to solidify. For example, leads 3b may already be pre-formed when providing second substrate 3.

First substrate 2 may be provided in a row or array of a plurality of said first substrates (not shown) for manufacturing a plurality of molded electronic packages substantially simultaneously. To that end, first substrate 2 may comprise a protruding portion 2b, as shown in Figure 1, by which first substrate 2 is connected to a frame (not shown), such as a lead frame. In an example, molded electronic package 1a can be singulated from said frame by physically severing the connection between protruding portion 2b and said frame. Singulation may include one or more actions from a group consisting of punching or cutting and may further include lead formation, and may for example be performed after applying the molding compound and allowing the molding compound to solidify.

Similarly, second substrate 3 may be provided in a row or array comprising a plurality of said second substrates (not shown) for manufacturing a plurality of molded electronic packages substantially simultaneously. Furthermore, a plurality of spring members 5 may be provided on respective second substrates 3. Second substrate 3 may comprise a protruding portion (not shown) by which second substrate 3 is connected to a frame (not shown), such as a lead frame. In an example, molded electronic package 1a can be singulated from said frame by physically severing the connection between said protruding portion and said frame. Singulation may include one or more actions from a group consisting of punching or cutting and may further include lead formation, and may for example be performed after applying the molding compound and allowing the molding compound to solidify.

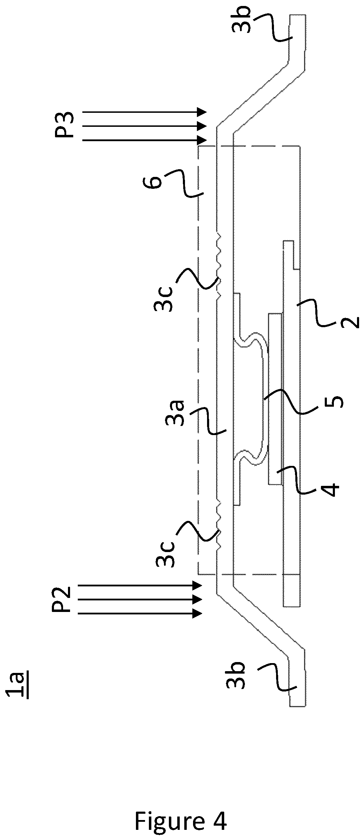

In Figure 4, a cross-sectional view of molded electronic package 1a according to another embodiment of the present disclosure is shown. Various elements shown in Figure 4 may be identical or similar to that of Figure 2. A detailed description thereof is therefore omitted.

The cross-section in Figure 4 main differs from that shown in Figure 2 in that respective portions of second substrate 3 extend out of body of solidified molding compound 6 at opposing sides. For example, first leads 3b may be arranged at both sides of molded electronic package 1a. In this embodiment, during manufacturing, forces P2 and P3 may be applied to both sides of second substrate 3 in a balanced manner to deform spring member 5 and press second contact portion 5b against electronic component 4 to form the physical and electrical connection between spring member 5 and electronic component 4. After the molding compound is sufficiently solidified, body of solidified molding compound 6 is formed which mutually fixates electronic component 4 and spring member 5 and maintains spring member 5 in physical and electrical contact with spring member 5.

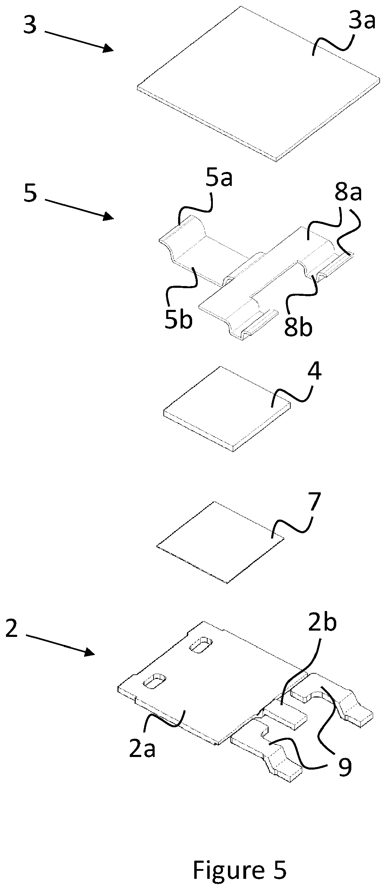

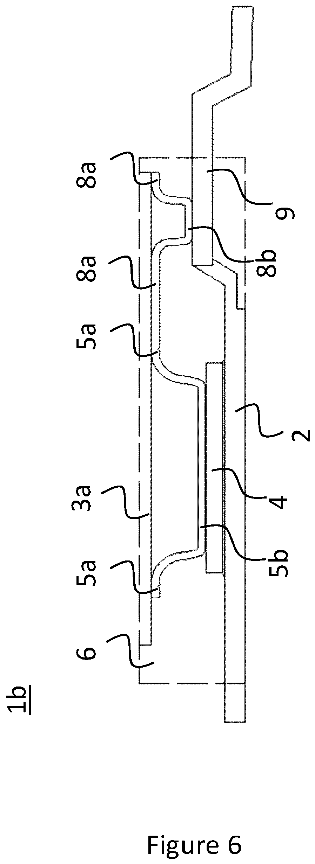

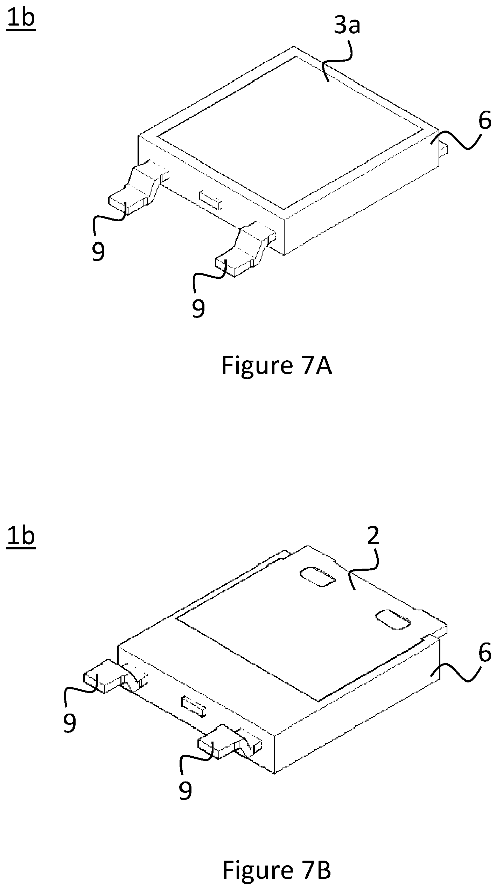

In Figure 5, an exploded view of part of a molded electronic package 1b according to another embodiment of the present disclosure is shown. Figure 6 shows a cross-sectional view of molded electronic package 1b according to an embodiment of the present disclosure, and Figures 7A and 7B show a corresponding perspective view of molded electronic package 1b.

Molded electronic package 1b of Figures 5-7B mainly differs from molded electronic package 1a of Figures 1-4 in that molded electronic package 1b further comprises further package contacts 9 and a further spring member comprising a first further contact portion 8a and a second further contact portion 8b. Furthermore, in this embodiment, second substrate 3 may be thermally conductive, and need not comprise any leads. In this embodiment, second substrate 3 comprises a surface that is at least partially exposed to an outside of molded electronic package 1b and may form a heatsink for electronic component 4.

In this embodiment, the further spring member is integrally connected to spring member 5. However, the present disclosure is not limited thereto, and the further spring member may instead be a separate and/or spaced apart spring member.

Similarly to spring member 5, the further spring member may be arranged such that it is fixated with respect to second substrate 3. For example, first further contact portion 8a is attached to second substrate 3 via an adhesive layer, such as a thermally conductive adhesive layer. Second further contact portion 8b physically contacts and is electrically connected to further package contacts 9.

Furthermore, similarly to spring member 5, the further spring member may be deformed and second further contact portion 8a may be pressed against further package contacts 9 by the force applied to second substrate 3 at least during at least part of the step of allowing the molding compound to solidify.

Alternatively to the above, although not shown in the figures, when the further spring member is not integrally connected to spring member 5, the further spring member may be fixated relative to package contacts 9 instead, and the applied force may allow the further spring member to deform such that first further contact portion 8a presses against second substrate 3.

After the molding compound has solidified, body of solidified molding compound 6 may mutually fixate first substrate 2, second substrate 3, electronic component 4, spring member 5 and the further spring member. Furthermore, body of solidified molding compound may maintain second further contact portion 8b to be in physical and electrical contact with package contacts 9.

Further package contacts 9 may be comprised in a same lead frame as first substrate 2 or second substrate 3 during manufacturing, as will be appreciated by a person skilled in the art. In that case, singulation of molded electronic package 1b may further comprise severing a physical connection between package contacts 9 and the lead frame.

Furthermore, further package contacts 9 may extend out of body of solidified molding compound 6 and provide external access to one or more terminals of electronic component 4. In this embodiment, since spring member 5 and the further spring member are integrally connected, second substrate 3 need not be electrically conductive, and further package contacts 9 may be electrically connected to electronic component via spring member 5 and the further spring member. In another embodiment, spring member 5 and the further spring member are not integrally connected, and second substrate 3 is electrically conductive such that further package contacts 9 are electrically connected to electronic component 4 via spring member 5, second substrate 3 and the further spring member.

Although not shown in the figures, additional package contacts may be arranged and be electrically connected to additional terminals of electronic component 4, for example using additional further spring members, bondwires, or the like.

In the above embodiments, second substrate 3 forms a heatsink and/or forms an electrical connection providing external access to a terminal of electronic component 4. However, the present disclosure is not limited thereto. Although not shown in the figures, in another embodiment, second substrate 3 may comprise a PCB with an electrical circuit arranged thereon, said electrical circuit being electrically connected to electronic component 4 via spring member 5. The electrical circuit may be arranged on a dielectric layer of the PCB.

The ensuing description above provides preferred exemplary embodiment(s) only, and is not intended to limit the scope, applicability, or configuration of the disclosure. Rather, the ensuing description of the preferred exemplary embodiment(s) will provide those skilled in the art with an enabling description for implementing a preferred exemplary embodiment of the disclosure, it being understood that various changes may be made in the function and arrangement of elements, including various modifications and/or combinations of features from different embodiments, without departing from the scope of the present disclosure as defined by the appended claims.

## Claims

1. A molded electronic package, comprising:
a first substrate;
a second substrate;
an electronic component arranged on the first substrate;
a spring member arranged between the second substrate and the electronic component, the spring member comprising a first contact portion being fixated relative to the second substrate, and a second contact portion physically contacting the electronic component; and
a body of solidified molding compound configured to encapsulate the electronic component and the spring member and to mutually fixate the first substrate, the second substrate, the electronic component and the spring member,
wherein the second substrate and the spring member are electrically and/or thermally conductive.

2. The molded electronic package according to claim 1, wherein the spring member is fixated to the second substrate by:
an adhesive layer, preferably comprising a conductive adhesive material such as a solder material; and/or
a recess in the second substrate in which the first contact portion is arranged, the recess being configured to mechanically lock a position of the spring member in a direction parallel to the second substrate; and/or
one or more protrusions extending from the second substrate and surrounding the first contact portion, the one or more protrusions being configured to mechanically lock a position of the spring member in a direction parallel to the second substrate.

3. The molded electronic package according to any of the previous claims, wherein the second substrate and the spring member are thermally conductive, wherein at least a portion of a surface of the second substrate is exposed to an outside of the molded electronic package, the second substrate forming a heatsink for the electronic component.

4. The molded electronic package according to any of the previous claims, wherein the second substrate and the spring member are electrically conductive, and wherein the second substrate comprises:
a planar portion, the spring member being arranged in between the planar portion and the electronic component; and
a first lead integrally connected to the planar portion and extending from said planar portion and out of the body of solidified molding compound,
wherein the first lead is electrically connected to a terminal of the electronic component via the planar portion and the spring member, and forms a package contact of the molded electronic package.

5. The molded electronic package according to claim 1 or 2, wherein the second substrate comprises a printed circuit board, 'PCB', comprising a dielectric layer and a circuit arranged on the dielectric layer, wherein the circuit is electrically connected to the electronic component through the spring member.

6. The molded electronic package according to any of the previous claims, wherein the spring member comprises an alloy including copper, such as a beryllium copper alloy or a titanium copper alloy.

7. The molded electronic package according to any of the previous claims, wherein the first substrate is electrically conductive and is electrically connected to a terminal of the electronic component, wherein the first substrate comprises a pad portion on which the electronic component is arranged, and
wherein the pad portion comprises a surface that is exposed to an outside of the molded electronic package, said surface forming a package contact of the molded electronic package, and/or wherein the first substrate further comprises a second lead integrally formed with the pad portion, said second lead extending from said pad portion and out of the body of solidified molding compound, wherein the second lead forms a package contact of the molded electronic package; and/or
wherein the electronic component comprises a semiconductor die having a circuit integrated thereon, wherein the circuit comprises a plurality of terminals corresponding to terminals of the electronic component, wherein the first substrate preferably comprises a die pad.

8. The molded electronic package according to any of the previous claims, further comprising:
a further package contact, a first end thereof being external to the body of solidified molding compound, and a second end thereof being encapsulated by the body of solidified molding compound;
a further spring member comprising a first further contact portion contacting the second substrate, and a second further contact portion contacting the further package contact, wherein the further spring member is electrically conductive,
wherein the further spring member is preferably integrally connected to the spring member.

9. The molded electronic package according to claims 4 and 7, wherein the planar portion and the pad portion extend substantially parallel to one another.

10. A method for manufacturing a molded electronic package, the method comprising:
a) providing a first substrate, a second substrate, an electronic component and a spring member, wherein the electronic component is arranged on the first substrate, wherein the second substrate and the spring member are electrically and/or thermally conductive;
b) arranging the spring member in between the second substrate and the electronic component, wherein a first contact portion of the spring member is fixated relative to the second substrate, and wherein a second contact portion of the spring member is arranged contacting the electronic component;
c) applying a molding compound; and
d) allowing said molding compound to solidify to thereby form a body of solidified molding compound encapsulating the electronic component and the spring member and mutually fixating the first substrate, the second substrate, the electronic component, and the spring member,
wherein the method further comprises applying a force to the second substrate at least during at least part of step d), said force allowing the second contact portion of the spring member to deform and press against the electronic component.

11. The method according to claim 10, wherein step b) further comprises fixating the spring member relative to the second substrate by:
an adhesive layer, preferably comprising a conductive adhesive material such as a solder material; and/or
a recess in the second substrate in which the first contact portion is arranged, the recess being configured to mechanically lock a position of the spring member in a direction parallel to the second substrate; and/or
one or more protrusions extending from the second substrate and surrounding the first contact portion, the one or more protrusions being configured to mechanically lock a position of the spring member in a direction parallel to the second substrate.

12. The method according to claim 10 or 11, wherein at least part of a surface of the second substrate is kept clear of molding compound, and wherein the force is applied to said part of the surface of the second substrate; and/or
wherein a first end portion and an opposing second end portion of the second substrate are kept clear of molding compound, and wherein the force is applied to said first end portion and second end portion; and/or
wherein the second substrate is thermally conductive and forms a heatsink for the electronic component.

13. The method according to any of the claims 10-12, wherein the second substrate and the spring member are electrically conductive, and wherein the spring member is electrically connected to a terminal of the electronic component,
wherein, in so far as depending on claim 12, at least one of the first end portion and second end portion preferably forms a package contact of the molded electronic package.

14. The method according to any of the claims 10-13, wherein the method further comprises:
providing a further package contact and a further spring member, the further spring member being electrically conductive and preferably being integrally connected to the spring member; and
arranging the further spring member in between the second substrate and the further package contact, wherein a first further contact portion of the further spring member contacts the second substrate and a second further contact portion of the further spring member contacts the further package contact,
wherein the further package contact comprises an end portion that is kept clear of molding compound, wherein the body of solidified molding compound mutually fixates the first substrate, the second substrate, the electronic component, the spring member, and the one or more further spring members,
wherein the applied force, or a further applied force, allows the first or second further contact portion of the further spring member to deform and press against the second substrate or the further package contact, respectively.

15. The method according to any of the claims 10-14, wherein the electronic component is fixated to the first substrate using an adhesive layer, preferably a conductive adhesive such as using solder material, or wherein the method comprises fixating the electronic component to the first substrate using an adhesive layer.
